# EUROPÄISCHE PATENTSCHRIFT

(11) **EP 0 339 385 B1**
(45) Veröffentlichungstag und Bekanntmachung des Hinweises auf die Patenterteilung: **21.09.1994**
(21) Anmeldenummer: 89106621.9
(22) Anmeldetag: 13.04.1989
(51) Int. Cl.: H01L 21/316, H01L 21/82, H01L 21/225

(54) **Verfahren zum Herstellen borhaltiger und/oder phosphorhaltiger Silikatglasschichten für höchstintegrierte Halbleiterschaltungen**
Method of producing boron-containing and/or phosphorous-containing silicate glass layers for highly integrated circuits
Procédé pour fabriquer des couches de verre silicaté contenant du bore et/ou du phosphore, pour circuits semi-conducteurs ayant la plus haute densité d'intégration

(30) Priorität: 26.04.1988 DE 3814093; 09.09.1988 DE 3830796
(43) Veröffentlichungstag der Anmeldung: 02.11.1989
(73) Patentinhaber: SIEMENS AKTIENGESELLSCHAFT, 80333 München (DE)
(72) Erfinder: Treichel, Helmuth, Dipl.-Ing., D-8900 Augsburg (DE); Fuchs, Dieter, Dipl.-Ing., D-8000 München 50 (DE); Hieber, Konrad, Dr., D-8214 Bernau (DE); Kruck, Thomas, Prof. Dr., D-5042 Erftstadt (DE); Spindler, Oswald, Dr., D-8011 Vaterstetten (DE); Neureither, Bernhard, Dipl.-Ing., D-8000 München 83 (DE)

(56) Entgegenhaltungen:
- US-A- 4 217 375
- US-A- 4 433 008
- JOURNAL OF VACUUM SCIENCE & TECHNOLOGY/SECTION B, Band 5, Nr. 6, November/Dezember 1987, Seiten 1555-1563, American Vacuum Society, Woodbury, NY, US; F.S. BECKER et al.: "Low pressure deposition of high-quality SiO2 films by pyrolysis of tetraethylorthosilicate"
- EXTENDED ABSTRACTS, Band 86-2, 19.-24. Oktober 1986, Seiten 396-397, Princeton, NJ, US; F.S. BECKER et al.: "Low pressure deposition of teos-arsenosilicateglass (AsSG) for trench doping"
- IEDM 1985, INTERNATIONAL ELECTRON DEVICES MEETING, TECHNICAL DIGEST, Washington, DC, 1.-4. Dezember 1985, Seiten 702-705, IEEE, New York, US; K. YAMADA et al.: "A deep-trenched capacitor technology for 4 mega bit dynamic RAM"
- SUPPLEMENTS OF THE 18TH INT. CONF. ON SOLID STATE DEVICES AND MATERIALS, Tokyo, 1986, JAPANESE JOURNAL OF APPLIED PHYSICS, 20.-22. August 1986, Seiten 299-307, Tokyo, JP; H. BINDER et al.: "Doping of trench capacitors for 4 megabit DRAMs"

## Beschreibung

Die Erfindung betrifft ein Verfahren zum Herstellen borhaltiger und/oder phosphorhaltiger SiO₂-Schichten wie Borsilikatglasschichten, Phosphorsilikatglasschichten, Borphosphorsilikatglasschichten oder Borarsensilikatglasschichten, wie sie als Isolationsschichten zwischen Leitbahnebenen und/oder als Passivierungsschichten und/oder als Diffusionsquellen zur Erzeugung von dotierten Bereichen in Siliziumsubstraten bei der Herstellung höchstintegrierter Halbleiterschaltungen verwendet werden, durch Abscheidung der Schichten nach erfolgter Zersetzung von elementorganischen, die Elemente enthaltenden Verbindungen aus der Gasphase.

Bor- und/oder phosphorhaltige Silikatglasschichten finden vielseitige Verwendung in der Mikroelektronik. Der Trend zu höherer Packungsdichte in der Fertigung von höchstintegrierten Schaltkreisen, wie zum Beispiel 4M-DRAM, stellt dabei neue Anforderungen an die Eigenschaften dieser Schichten.

Borsilikatglasschichten werden z.B. als Feststoffdiffusionsquellen für p-Dotierungen bei der Herstellung von Grabenkondensatoren für DRAMs zum Erzeugen einer definierten Dotierung in Seitenwänden und Böden von in Halbleitersubstraten eingeätzten Gräben (Trenches) eingesetzt. Höchstintegrierte DRAM-Speicher wie zum Beispiel das 4M-DRAM oder das 16M-DRAM werden mit sogenannten Trenchzellen (Kondensator-Speicherzellen) mit hohem Aspektverhältnis a (a = Verhältnis von Tiefe zu Durchmesser) realisiert. Nähere Einzelheiten finden sich in einem Bericht von F. S. Becker und S. Röhl im ECS Extended Abstracts 86-2, 1986, Seiten 394/395. Der Einsatz von Trenchzellen führt vor allem dann zu einem Flächengewinn und damit zu höherer Integrationsdichte, wenn die Zellen mit möglichst geringem Abstand zueinander angeordnet werden können. Der minimal mögliche Abstand hängt im wesentlichen von folgenden Größen ab:
a) Zellentiefe (bzw. Aspektverhältnis a),
b) p-Substratdotierung (Bordotierung),
c) n⁺-Eindringtiefe xⱼ und Oberflächenkonzentration cₛ (Arsendotierung bei vorhandener HiC-Dotierung = Kontakt des Transistors zum Kondensator (planarer Teil)).

Damit durch die dichte Packung der Trenchzellen die elektrischen Eigenschaften nicht verschlechtert werden, ist es wesentlich, daß die p-Substratdotierung (Bor) auf das Zellenfeld beschränkt bleibt und die n⁺-Dotierung (Arsen) mit hoher Oberflächenkonzentration, aber geringer Eindringtiefe den Trench umgibt (siehe EP-A-0 271 072. Dies kann bevorzugt dadurch erreicht werden, daß der Dotierstoff aus einer im Trench abgeschiedenen Hilfsschicht in das Siliziumsubstratmaterial eindiffundiert wird. Da hierbei die abgeschiedene Hilfsschicht den Dotierstoff in sehr hoher Konzentration enthält, kommt es nicht wie bei Dotierungen aus der Gasphase (Implantation) zu lokalen Konzentrationsschwankungen im Silizium.

Die im Bereich des Zellenfeldes benötigte hohe Bordotierung wird bislang durch eine sogenannte p-Wannentechnik (Borimplantation mit anschließendem Diffusionsschritt) erzeugt. Mit diesem Verfahren sind folgende Nachteile verbunden:
a) Zur Definition der bordotierten Gebiete ist eine eigene Phototechnik mit mehreren Masken und entsprechenden Folgeschritten notwendig.
b) Zum Erreichen der notwendigen großen Wannentiefe (ca. 600 nm) ist ein zeitintensiver Hochtemperaturschritt notwendig. Trotz dieses Diffunsionsschrittes nimmt die Borkonzentration in den tieferen Bereichen zum Beispiel der Trenchzellen hin ab, was sich negativ auf die Kapazität der Kondensatoren und deren Leckstromempfindlichkeit bei verkleinertem Zellenabstand auswirkt.
c) Die Transistoren, die in der p-Wanne liegen, zeigen von Peripherietransistoren abweichende elektrische Eigenschaften und müssen zusätzlich optimiert werden. Die p/n-Kapazität im Bereich des Zellenfeldes ist hoch, die p/n-Durchbruchspannung ist niedrig (siehe auch EP-A-0 259 605).

Ein Verfahren gemäß dem Oberbegriff zum Herstellen von Borsilikatglasschichten für Grabenkondensatoren für DRAMs ist beispielsweise aus der EP-A-0 259 605 bekannt.

Phosphorsilikatglasschichten können z. B. aufgrund niedriger Dielektrizitätskonstanten als Isolationsschichten zwischen verschiedenen Metallisierungsebenen oder als Passivierungsschichten bei nöchstintegrierten Halbleiterschaltungen eingesetzt werden. Eine Phosphorsilikatglasschicht bietet als Passivierungsschicht unter anderem mechanischen Schutz und wirkt als sogenanntes Gettermaterial für bewegliche Ionen wie Na⁺ oder andere Alkalien. Als weitere Einsatzmöglichkeit können Phosphorsilikatglasschichten als n⁺ -Feststoffdiffusionsquellen verwendet werden.

Die Niedertemperaturabscheidung von Phosphorsilikatglasschichten kann bevorzugt durch Oxidation von Silan und Phosphan mit Sauerstoff erreicht werden. Dabei sind folgende Verfahren möglich:
1. Atmospheric Pressure Chemical Vapor Deposition (APCVD)
2. Low Pressure Chemical Vapor Deposition (LPCVD)
3. Plasma Enhanced Chemical Vapor Deposition (PECVD)

Die Niedertemperatur-CVD-Abscheidung (bei ca. 450° C) des binären Phosphorsilikatglases durch Oxidation von Silan und Phosphan hat den Nachteil, daß die so gewonnene Schicht eine geringe Kantenbedeckung, Schichtdickenschwankungen und im Falle der Herstellung zur Verwendung als Feststoffdiffusionsquelle eine inhomogene Dotierstoffverteilung aufweist. Die Schicht kann sogar Sprünge aufweisen, die die Ausbeute an Bauelementen reduziert. Den Artikel von Z. J. Alexevieva et. al. in Thin Solid Films, 140 (1986), S. 269-276 ist Näheres über die Herstellung von Phosphorsilikatglasschichten durch PECVD zu entnehmen. Im Weiteren vergleicht Y. Shioya et. al. im Journal of the Electrochemical Society, Vol. 133, No. 9 (1986), S. 1943-1950 verschiedene Herstellungsmethoden.

Borphosphorsilikatglasschichten finden insbesondere als Isolationsschichten zwischen Verdrahtungsebenen, z. B. Aluminiumleiterbahnen Einsatz. Ein Isolationsoxid muß eine möglichst einebnende Wirkung haben, um eine hohe Ebenheit für die darauf zu strukturierenden Aluminiumleitbahnebenen (geringe Tiefenschärfe der sub-µm-Lithographie) zu gewährleisten. Bei der sogenannten Mehrlagenverdrahtung muß das Isolationsoxid über der ersten Aluminiumebene bei möglichst geringen Temperaturen abgeschieden werden, um Veränderungen des Aluminiums (bevorzugtes Wachstum einzelner Kristallite: Hillocks) zu vermeiden. Die Temperaturgrenze wird durch diese Eigenschaft des Aluminiums auf 300 bis 450° C je nach Dauer der Temperatureinwirkung begrenzt. Das Isolationsoxid, welches hier als Borphosphorsilikatglas verwendet wird, muß sowohl einebende als auch isolierende Eigenschaften aufweisen. Nähere Einzelheiten sind einem Bericht von F. S. Becker et. al. aus dem J. Vac. Sci. Technol. Vol. 4 (3), 1986, auf den Seiten 732 bis 744 zu entnehmen.

Für eine Niedertemperaturabscheidung von Borphosphorsilikatglas gibt es bislang folgende Möglichkeiten:
a) APCVD unter Verwendung von Silan, Boran, Phosphan und Sauerstoff.
b) PECVD entweder mit Silan und Sauerstoffplasma oder mit Tetraethylorthosilikat und Ozon-Plasma.
c) LPCVD in Rohrofenanlagen mit z. B. Tetraethylorthosilikat und z. B. Trimethylborat und Phosphan/Sauerstoff oder z. B. Triethylphosphat.

Die Verfahren haben folgende Nachteile:
zu a):
   1. Einsatz der gefährlichen und sehr giftigen Gase Silan, Boran und Phosphan.
   2. Das abgeschiedene Borphosphorsilikatglas muß noch einer Temperaturbehandlung unterzogen werden, zum Beispiel zum Nachverdichten, um eine Nindeststabilität über einen bestimmten Zeitraum zu gewährleisten und um das Borphosphorsilikatglas zu verfließen. Dieser Verdichtungsschritt bzw. Verfließschritt findet bei einer Temperatur zwischen 800 und l000° C statt und begrenzt somit ebenfalls die Einsatzfähigkeit des Isolationsoxides auf ein Herstellstadium, in dem noch keine Aluminiumleitbahnebene auf dem Bauelement aufgebracht ist.
Zu b):
   Entsorgungsprobleme durch das eingesetzte Ozon.
Zu c):
   1. Eine Abscheidung von Borphosphorsilikatglas in sogenannten Rohrofenanlagen mittels zum Beispiel Tetraethylorthosilikat und z.B. Trimethylborat und Phosphan/Sauerstoff oder z.B. Triethylphosphat erfolgt bei Temperaturen um 700° C und begrenzt die Einsatzfähigkeit des Isolationsoxids auf ein Herstellstadium, in dem noch keine Aluminiumleitbahnebene auf dem Bauelement aufgebracht worden ist.
   2. Die reproduzierbare Verdampfung des Trimethylborats (Flüssigkeit mit sehr hohem Dampfdruck) ist sehr aufwendig.
   3. Um Borphosphorsilikatglasschichten und auch Borsilikatglasschichten durch LPCVD zu erzeugen, werden, wie aus der europäischen Patentanmeldung 0 204 182 zu entnehmen ist, Abscheidungen mit Hilfe von organischen Silizium- bzw. Borverbindungen durchgeführt. Dazu müssen die einzelnen Komponenten aus verschiedenen Verdampfersystemen der LPCVD-Anlage zugeführt werden, was die Komplexität der Anlage (Rohrleitungen, Platzbedarf, Steuerung des Gasflusses, Dichtigkeit) und die Schwierigkeit bei der Prozeßführung (Regelung, Kompsition des Gasgemisches, Angleichung der Dampfdrücke, Variation der Konzentrationen, Erzielen einer Kantenbedeckung von möglichst 100 Prozent) erhöht.

Bei allen genannten Verfahren ist eine Steuerung der Bor- und Phosphorkonzentration nur über eine Änderung der Prozeßbedingungen (z.B. Abscheidetemperatur, Prozeßdruck, Gasfluß, Verdampfertemperatur oder ähnliches) möglich.

Borarsensilikatglasschichten können als Feststoffdiffusionsquelle für Arsen, z. B. zum Erzeugen der n⁺-Elektrode in Kondensatoren, oder als Simultandiffusionsquelle für Bor und Arsen eingesetzt werden. Bei der Fertigung von Transistoren in der Halbleitertechnologie wird eine aufwendige Implantationstechnik, gefolgt von Diffusionsschritten angewandt, um die Zielprofile von Bor und Arsen in den Gebieten der Transistoren (Basis, Gate, Emitter, Kollektor) zu erzeugen (hohe Konzentrationen, scharfe p/n-Übergänge). Desweiteren gibt es die Möglichkeit, Silizide wie z.B. Kobaltsilizid, Tantalsilzid oder Wolframsilizid aufzubringen, diese mit Ionenimplantation zu dotieren und in einem nachfolgenden Diffusionsschritt die Dotierstoffe Arsen bzw. Bor in das Siliziumsubstrat einzutreiben.

Bei der Fertigung der Kondensatoren in der Halbleitertechnologie wird zur Erzeugung der p-Wanne (Bor) die sogenannte p-Wannentechnik angewandt. Um die n⁺-Elektrode (Arsen) zu erzeugen, wird nach Formation der p-Wanne ein Arsensilikatglas abgeschieden und aus diesen in einem nachfolgenden Diffusionsschritt das Arsen in vorgegebener Oberflächenkonzentration und Eindringtiefe in das Siliziumsubstrat eingetrieben.

Werden Arsensilikatglasschichten (abgeschieden z.B. mit Arsenwasserstoff oder Arsentrichlorid) mit hoher Arsenausgangskonzentration einem Hochtemperaturschritt, z.B. zur Erzeugung der n⁺-Elektrode bei Kondensatoren oder zur Arsendiffusion bei der Transistorenerzeugung, unterworfen, so kann es während dieses Hochtemperaturschrittes zur Ausscheidung kristalliner Bestandteile im Arsensilikatglas kommen. Diese kristallinen Bereiche (Kristallite) können auf der Halbleiteroberfläche punktförmige Störungen hervorrufen und somit die Ausbeute von Halbleiterbauelementen oder höchstintegrierten Schaltkreisen verringern. Um die Kristallbildung bei der Arsendiffusion aus Arsensilikatglas, die abhängig von den Parametern der nachfolgenden Temperaturbehandlung (Temperatur, Zeit und Ambient) und der Arsenkonzentration im Arsensilikatglas ist, zu vermeiden, kann man dem Arsensilikatglas einen geringen Boranteil zumischen. Bei der Bildung der ternären Mischsilikatglases Borarsensilikatglas wirkt das eingebaute Boroxid (B₂O₃) als Glasbildner und verhindert somit die Kristallitbildung.

Aufgabe der Erfindung ist es daher, ein Verfahren anzugeben, mit dem folgende Möglichkeiten erreichbar sind:
1. Abscheidung einer Borsilikatglasschicht zur Erzeugung von Borsilikatglas als Diffusionsquelle in höchstintegrierten Schaltungen, insbesondere bei der Herstellung von DRAMs mit grabenförmigen Kondensatoren.
2. Abscheidung einer Phosphorsilikatglasschicht, die als n⁺-Diffusionsquelle geeignet ist oder als Intermetallisationsschicht oder als Passivierungsschicht.
3. Abscheidung einer Borphosphorsilikatglasschicht bei niedrigen Temperaturen, so daß eine Anwendung als Isolationsoxid zwischen Aluminiumleitbahnen ermöglicht wird.
4. Abscheidung einer Borarsensilikatglasschicht mit einem durch Bor stabilisierten Arsensilikatglas, welches als Diffusionsquelle für Arsen zum Erzeugen der n⁺-Elektrode in Kondensatoren geeignet ist.
5. Abscheidung einer Borarsensilikatglasschicht, die als Simultandiffusionsquelle für Bor und Arsen einsetzbar ist.

Diese Aufgabe wird durch ein Verfahren der eingangs genannten Art dadurch gelöst, daß erfindungsgemäß für die Zersetzung solche elementorganische Verbindungen verwendet werden, welche die Boratome und/oder Phosphoratome, die Siliziumatome und die Sauerstoffatome bereits im vorgegebenen Verhältnis enthalten und daß die Zersetzung thermisch oder durch Anregung der Verbindungen in einem elektromagnetischen Wechselfeld durchgeführt wird.

In einer Weiterbildung des Erfindungsgedankens ist vorgesehen, zum Herstellen einer borhaltigen SiO₂-Schicht als elementorganische Si-B-O-Verbindung eine Verbindung der Struktur (R₃SiO)₃B mit R = H, Aryl, Alkyl oder Allyl, vorzugsweise Tristrimethylsilylborat (B(OSi(OH₃)₃)₃) zu verwenden.

Es liegt auch im Rahmen der Erfindung, daß zur Herstellung einer als Diffusionsquelle dienenden Bor und/oder Phosphor und Arsen enthaltenden Silikatglasschicht zusätzlich zu der Boratome und/oder Phosphoratome, Siliziumatome und Sauerstoffatome in einem Molekül enthaltenden Verbindung eine organische Arsenverbindung zersetzt wird.

Weitere Ausgestaltungen der Erfindung, insbesondere weitere Substanzen sowie die Verwendung des erfindungsgemäßen Verfahrens zur Herstellung von grabenförmigen Kondensatorspeicherzellen ergeben, sich aus den Unteransprüchen.

Durch das Verfahren nach der Lehre der Erfindung ist die Möglichkeit gegeben, Diffusionsquellen für Bor, Phosphor bzw. Bor zusammen mit Arsen oder Phosphor auf vereinfachte Weise dort zu erzeugen, wo sie benötigt werden. Die Abscheidung borhaltiger SiO₂-Schichten kann bei niedrigen Temperaturen, zum Beispiel im Bereich von 250°C -800°C, durchgeführt werden. Die Zersetzung findet dabei entweder auf rein pyrolytischem Wege oder durch Anregung der Moleküle in einem elektromagnetischen Wechselfeld (PECVD) statt. Beim PECVD-Verfahren kann die Zersetzung durch milde thermische Anregung unterstützt werden. Das Silizium-Bor-Verhältnis der abzuscheidenden Schicht (Borsilikatglas, Borphosphorsilikatglas, Borarsensilikatglas) bzw. das Silizium-Phosphor-Verhältnis der abzuscheidenden Schicht kann sowohl durch die geeignete Wahl der Silizium-Sauerstoff-Bor(Phosphor)-Komponenten als auch durch Modifikation des Substituenten R am Silizium definiert eingestellt werden.

Die Abscheidungen erfolgen unter Verwendung von solchen Verbindungen, die sowohl Silizium und Sauerstoff als auch Bor und/oder Phosphor in vorgegebenem Verhältnis enthalten, bezeichnet als Si-O-B(P)-Verbindungen.

Die verwendeten Substanzklassen sind:

### I: Si-O-B-Verbindungen :

1. (R₃SiO)₃B mit R = H, Alkyl, Cycloalkyl oder Aryl, 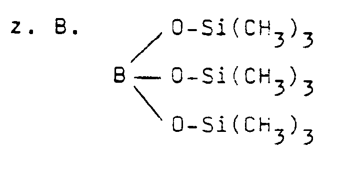 mit R = CH₃.
2. (OBOSiR₃)₃ mit R = H, Alkyl, Cycloalkyl oder Aryl, 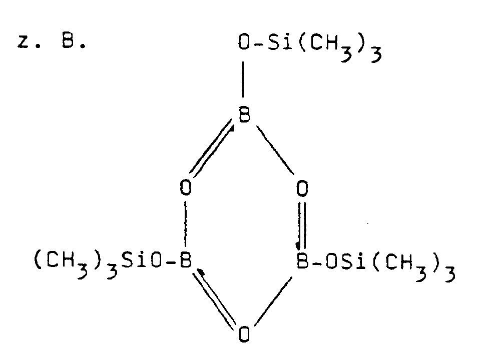 mit R = CH₃.
3. (R₃SiO)₂B-O-Si(R₂)-O-B(OSiR₃)₂ mit R = H, Alkyl, Cycloalkyl oder Aryl, 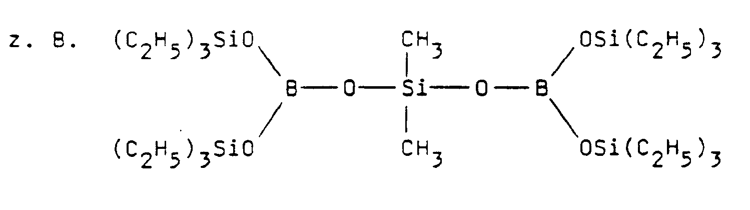 mit R = C₂H₅.
4. (R₃SiO)₂B-O-B(OSiR₃)₂ mit R = H, Akyl, Cycloalkyl oder Aryl, 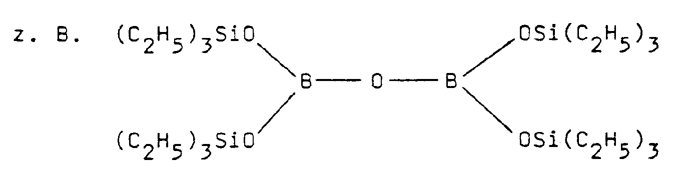 mit R = C₂H₅.

Dabei kann das Silizium-Bor-Verhältnis der abzuscheidenden Schichten (BSG; BPSG) sowohl durch die geeignete Wahl der Si-O-B-Komponente als auch durch Modifikation des Restes R am Silizium definiert eingestellt werden.

### II. Si-O-P-Verbindungen :

a) Derivate der Phosphorsäure :
   1. (R₃SiO) (R′O)₂PO mit R und R′ = H, Alkyl, Cycloalkyl oder Aryl, 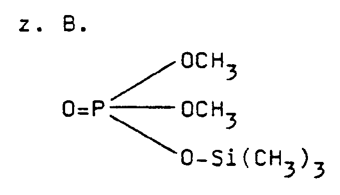 mit R = R′ = CH₃.
   2. (R₃SiO)₂(R′O)PO mit R und R′ = H, Alkyl, Cycloalkyl oder Aryl, 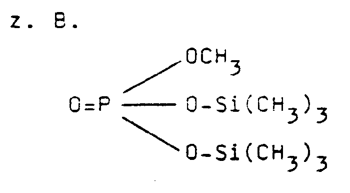 mit R = R′ = CH₃.
   3. (R₃SiO)₃PO mit R = H, Alkyl, Cycloalkyl oder Aryl, 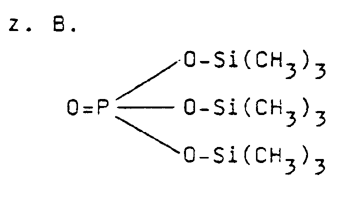 mit R = CH₃.
   4. (RO)₂PO(OSi(OR′)₃) mit R und R′ = H, Alkyl, Cycloalkyl oder Aryl, 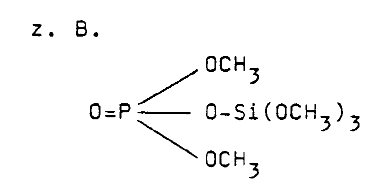 mit R = R′ = CH₃.
   5. OP(OR)₂(OSi(OSiR′₃)₃) mit R und R′ = H, Alkyl, Cycloalkyl oder Aryl, 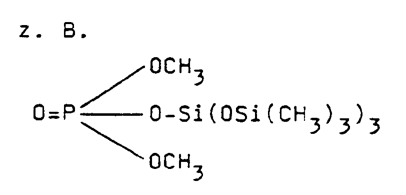 mit R = R′ = CH₃.
b) Derivate der Phosphorigen Säure :
   1. (R₃SiO) (R′O)₂P mit R und R′ = H, Alkyl, Cycloalkyl oder Aryl, 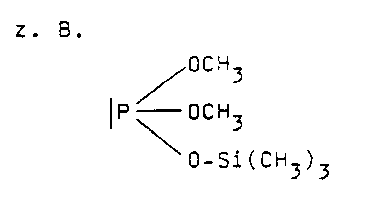 mit R = R′ = CH₃.
   2. (R₃SiO)₂(R′O)P mit R und R′ = H, Alkyl, Cycloalkyl oder Aryl, 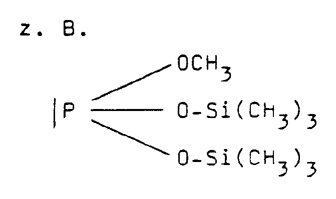 mit R = R′ = CH₃.
   3. (R₃SiO)₃P mit R = H, Alkyl, Cycloalkyl oder Aryl 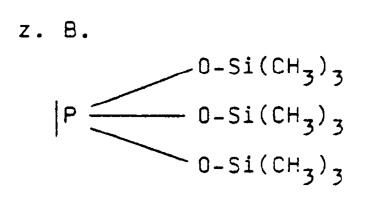 mit R = CH₃.
   4. (RO)₂P(OSi(OR′)₃) mit R und R′ = H, Alkyl, Cycloalkyl oder Aryl, 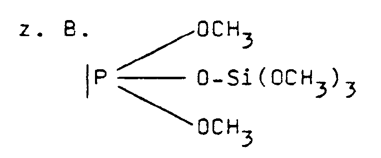 mit R = R′ = CH₃.
   5. ((RO)₂PO)₃SiR′ mit R und R′ = H, Alkyl, Cycloalkyl oder Aryl, 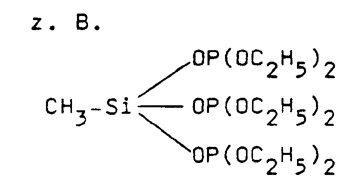 mit R = C₂H₅ und R′ = CH₃.

Die Verbindungen der aufgeführten Substanzklassen sind ungiftig und leicht zu handhaben.

Weitere Einzelheiten der Erfindung, insbesondere Anwendungsbeispiele, sowie zur Durchführung der Abscheideverfahren geeignete Apparaturen werden nachfolgend anhand von Ausführungsbeispielen beschrieben.

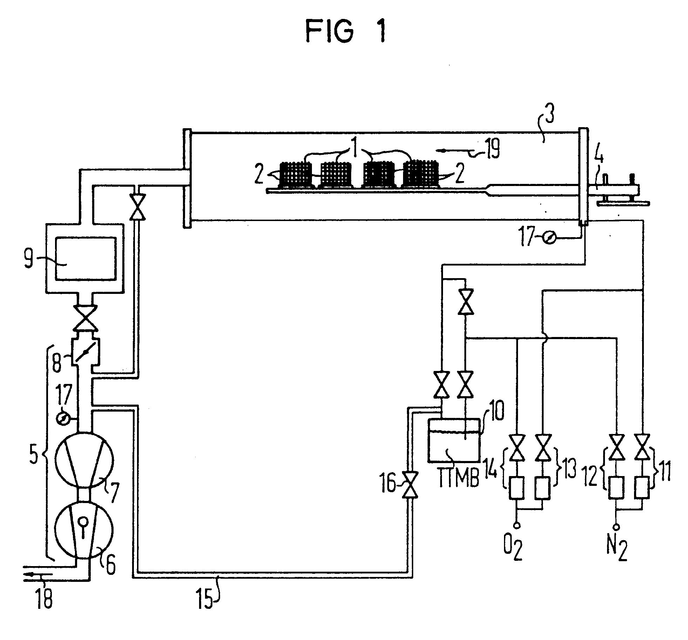

Figur 1 stellt im Schnittbild eine Vorrichtung dar, in welcher z. B. nach dem erfindungsgemäßen Verfahren aus Silizium bestehende Halbleitersubstratscheiben 2 mit einer Borsilikatglasschicht gemäß dem folgenden 1. Ausführungsbeispiel (im einzelnen nicht dargestellt) versehen werden. Diese Vorrichtung unterscheidet sich von der in der europäischen Patentanmeldung 0 204 182 beschriebenen Anordnung dadurch, daß nur ein Verdampfer für die Silizium-, Sauerstoff-und Boratome enthaltende Verbindung vorhanden ist und sich dadurch sehr einfach gestalten läßt.

Als Abscheideanlage kann ein im Handel erhältlicher (z. B. Heraeus Cantilever) Niederdruck-Abscheideofen eingesetzt werden. Die in den als Quarzkäfig ausgebildeten, als "Boote" bezeichneten Scheibenhalterungen 1 stehende Siliziumscheiben 2 werden mittels einer Schiebevorrichtung 4 in das Reaktonsrohr 3 eingebracht. Durch einen Pumpstand 5, bestehend aus Vorpumpe 6, Wälzkolbenpumpe 7 und Regelventil 8 wird über einen Abscheider (Filter) 9 das Reaktionsrohr 3 evakuiert (siehe Pfeil 18) und dann das Prozeßgas, welches zum Aufbau der auf den Substratscheiben 2 aufzubringenden Borsilikatglasschicht erforderlich ist, eingeleitet.

Das Prozeßgas, bestehend aus zum Beispiel Tristrimethylsilylborat (TTMB), wird in einem Verdampfer 10, der sich auf einer Temperatur im Bereich von 25 - 40 °C befindet, verdampft und an der Seite des Reaktors 3 in den Reaktor eingelassen (siehe Pfeil 19), an der auch die Substratscheiben (1, 2, 4) eingeführt worden sind.

Der Abscheidedruck im Reaktionsraum 3 wird im Bereich von 50 bis 400 Pa eingestellt; als Abscheidetemperatur wird zum Beispiel 800°C gewählt.

Durch zusätzliche Anschlußleitungen und Strömungsgeber mit Ventilen 11, 12, 13, 14 ist es möglich, Stickstoff (N₂) oder Sauerstoff (O₂) durch den Verdampfer 10 hindurchperlen zu lassen. Über eine Evakuierleitung 15 und das Ventil 16 ist der Verdampfer 10 mit dem Pumpstand 5 verbunden. Über die mit Bezugszeichen 17 bezeichneten Meßgeräte (Baratron) wird der Druck kontrolliert. Weitere, nicht mit Bezugszeichen versehene Symbole in der Zeichnung stellen Ventile für die einzelnen Zuleitungen dar.

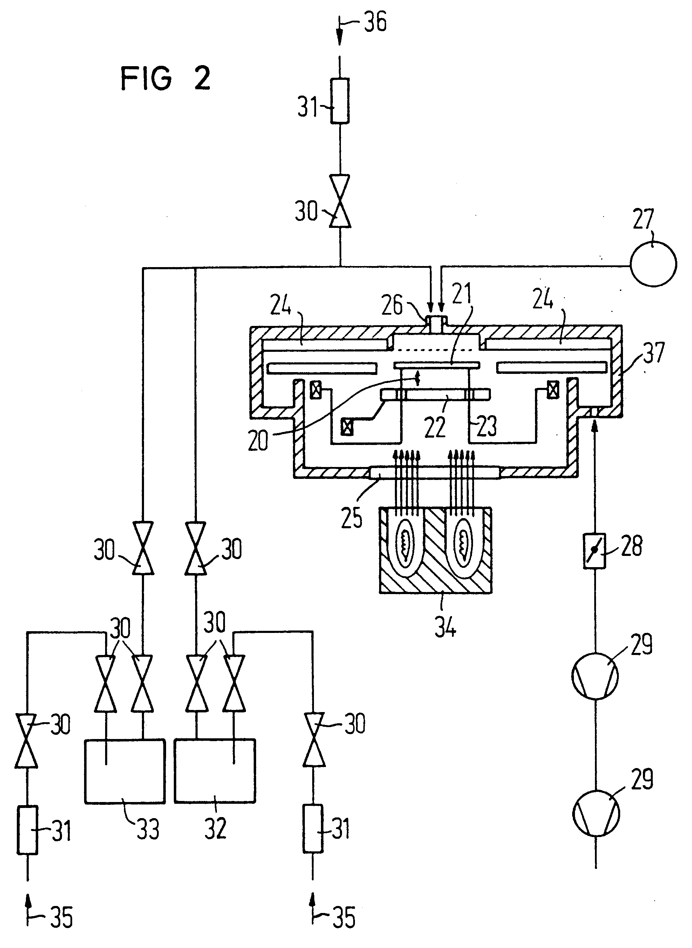

Figur 2 zeigt in schematischer Darstellung eine Anlage zur chemischen Dampfabscheidung in einem elektromagnetischem Wechselfeld (PECVD). In der Reaktorkammer ist eine zu bearbeitende Halbleiterscheibe 21 auf einem Halbleiterscheibenlift 23 zwischen dem Gaseinlaßbereich 26 und dem Suszeptor 22 angeordnet. Die Bewegung des Halbleiterscheibenliftes 23 ist mit einem Doppelpfeil 20 angedeutet. Zur Evakuierung der Reaktorkammer 37 sind zwei Vakuumpumpen 29 vorgesehen, die über ein Butterflyventil 28 angeschlossen sind. Zur Erzeugung des elektromagnetischen Wechselfeldes wird ein RF-Generator 27 eingesetzt, wobei einzelne Bereiche der Reaktorkammer 37 durch Isolatoren 24 abgeschirmt sind. Die flüssigen Ausgangsverbindungen werden in einem Verdampfergefäß (Bubbler) 32 für die elementorganische Borkomponente und/oder in einem Verdampfergefäß 33 für die elementorganische Phosphorkomponente bereitgestellt, in die als Trägergas eingesetztes Helium zugeführt wird. Für die Zufuhr von Sauerstoff ist eine weitere Gaszuleitung 36 vorgesehen. Alle Gaszuleitungen sind mit Durchflußmengenregler 31 und Pneumatikventilen 30 versehen. Zur Einstellung der Abscheidetemperatur in der Reaktorkammer 37 sind Lampen bzw. ein Reflektormodul 34 vorgesehen, das die in der Reaktorkammer 37 befindliche Anordnung durch ein Quarzfenster 25 bestrahlt.

1. Ausführungsbeispiel: Herstellung von Borsilikatglas. Bei der erfindungsgemäßen Durchführung des im folgenden dargestellten Verfahrens ist es möglich, eine selbstjustierende Bordotierung des Siliziumsubstrates, zum Beispiel beschränkt auf den Bereich des Varaktorfeldes, zu erzeugen und das Dotierstoffprofil unabhängig von der Zellentiefe definiert einzustellen. Anstelle des p-Wannenimplantationskomplexes werden zum Beispiel nach der anisotropen Ätzung der Trenchzellen diese mit einer bordotierten SiO₂-Schicht, im folgenden Borsilikatglas genannt, mit vorgegebener Dotierstoffkonzentration und Schichtdicke ausgekleidet. Da es für eine gleichmäßige Dotierung zum Beispiel der Trenchzellenwände wichtigt ist, daß das Borsilikatglas eine Kantenbedeckung a zwischen 70 % und 100 % aufweist, wird das Borsilikatglas durch Zersetzung einer der obengenannten Silizium-Sauerstoff-Bor-Verbindungen, zum Beispiel Tristrimethylsilylborat, hergestellt. In einem konventionellen LPCVD-Heißwandreaktor gemäß Figur 1 erfolgt die Schichtaufbringung im 200 bis 800°C-Bereich, abhängig von Anwendung, Si-O-B-Verbindung und dem Substituenten R am Silizium, bei einem Prozeßdruck von 50 bis 400 Pa. Die Zersetzung der Ausgangsverbindungen erfolgt dabei auf pyrolytischem Wege. Der Dampf der organischen Si-O-B-Verbindung wird dabei am Rohreingang des Reaktors eingelassen. Die Höhe der Bordotierung des Borsilikatglases kann dabei sowohl durch Vorgabe der Si-O-B-Verbindung, Variation des Silizium-Substituenten R als auch in Grenzen durch Variation der Prozeßparameter wie Verdampfertemperatur, Trägergasmenge (Stickstoff oder Sauerstoff), Prozeßdruck oder Abscheidetemperatur eingestellt werden. Typische Verdampfertemperaturen liegen, abhängig von der eingesetzten Si-O-B-Verbindung, im Bereich von 25 bis 90°C.

Bei Herstellung der Borsilikatglasschicht in einem konventionellen PECVD-Reaktor gemäß Figur 2 erfolgt die Zersetzung der Ausgangsverbindungen durch gezielte Anregung in einem elektromagnetischen Wechselfeld. Die Schichtaufbringung erfolgt im Temperaturbereich von 350 bis 450° C, abhängig von Anwendung, Si-O-B-Verbindung und dem Substituenten R am Silizium, bei einem Prozeßdruck von 0,8 bis 1,3 kPa. Die organische Si-O-B-Verbindung wird dabei mittels eines Trägergases 35 (z. B. Helium) aus dem Verdampfergefäß 32 in die Reaktorkammer 37 eingebracht. Die Höhe der Bordotierung kann dabei wie im Falle des LPCVD-Verfahrens durch Variation der Prozeßparameter eingestellt werden.

Typische Prozeßparameter sind:
- Verdampfertemperatur: : 25 - 35° C
- Trägergasmenge (He): : 100 - 500 sccm
- Sauerstoffmenge: : 10 - 300 sccm
- RF-Leistung: : 400 - 700 W
- Elektrodenabstand: : 0,3 - 0,6 cm
- Prozeßdruck: : 0,8 - 1,3 kPa
- Abscheidetemperatur: : 350 - 450° C

Nach Abscheidung der Borsilikatglasschicht mit Dicken typischerweise zwischen 200 und 400 nm wird in einem anschließenden Hochtemperaturschritt im Bereich von 850 bis 1050°C oder durch Rapid Optical Annealing (ROA) im Bereich von 900 bis 1140° C (10 bis 240 sec) das Bor aus der Borsilikatglasschicht in das Siliziumsubstrat eingetrieben. Die Borkonzentration im Substrat läßt sich dabei sowohl über den Borgehalt im Borsilikatglas als auch über die Temperatur, die Dauer und den Ambienten während des Eintreibschrittes steuern.

Typische Parameter der Borausdiffusion durch Temperung sind:
a) Borgehalt der Borsilikatglasschicht zwischen 0,5 und 6 Gewichtsprozent,
b) Temperaturen zwischen 850 und 1050°C,
c) Temperzeiten zwischen 20 Minuten und 2 Stunden,
d) Stickstoff- oder Argon-Atmosphäre, Mischungen aus Stickstoff und Sauerstoff mit definiertem Verhältnis, Wasserdampf.

Typische Parameter der Borausdiffusion durch ROA sind:
a) Borgehalt der BSG-Schicht zwischen 0,5 und 6 Gewichtsprozent,
b) Temperaturen zwischen 900 und 1150° C,
c) Temperzeiten zwischen 10 und 240 sec,
d) N₂- oder Ar-Atmosphäre, Mischungen aus N₂ und O₂ mit definiertem Verhältnis, Wasserdampf.

Im Anschluß an den Borausdiffusionsschritt wird das Borsilikatglas durch eine Naßätzung entfernt, die eine hohe Selektivität gegenüber Silizium aufweist, wie zum Beispiel gepufferte Flußsäure.

2. Ausführungsbeispiel: Herstellung von Phosphorsilikatglas. Durch die erfindungsgemäße Durchführung des im folgenden dargestellten Verfahrens ist es möglich, Schichten zur Passivierung höchstintegrierter Bauelemente herzustellen. Die Schichtaufbringung erfolgt im Bereich von 350 - 450° C unter Verwendung einer Si-O-P-Verbindung mit einem hohen Verhältnis von Phosphor zu Silizium, z. B. Tris(triethylsilyl)phosphat, bei einem Prozeßdruck von 0,8 - 1,3 kPa in einem konventionellen PECVO-Reaktor (s. Figur 2). Die elementorganischen Dämpfe der Si-O-P-Verbindung werden mittels Trägergas 35 in die Reaktorkammer 37 eingebracht (100 - 500 sccm He). Der Phosphorgehalt der PSG-Schicht ist typischerweise im Bereich von 5 - 10 Gewichtsprozent und kann sowohl durch Vorgabe der Si-O-P-Verbindung, durch Variation des Restes R am Silizium als auch durch Variation der Prozeßparameter gesteuert werden.

Typische Prozeßparameter sind:
- Abscheidetemperatur: : 350 - 450° C
- Prozeßdruck: : 0,8 - 1,3 kPa
- Verdampfertemperaturen: : 25 - 45° C für die Si-O-P-Verbindung
- Trägergasmenge: : 100 - 500 sccm He
- O₂-Menge: : 10 - 300 sccm
- RF-Leistung: : 300 - 700 W
- Elektrodenabstand: : 0,3 - 0,6 cm

3. Ausfuhrungsbeispiel: Herstellung von Borphosphorsilikatglas.
Bei der erfindungsgemäßen Durchführung des im folgenden dargestellten Verfahrens ist es möglich, eine Borphosphorsilikatglasschicht bei Temperaturen zwischen 300 und 450° C abzuscheiden. Anstelle der bisher angewandten Verfahren wird das Borphosphorsilikatglas durch Zersetzung in einem elektromagnetischen Wechselfeld oder durch Pyrolyse einer Si-O-B-Verbindung, zum Beipiel Tris(trimethylsilyl)borat, und einer elementorganischen Phosphorverbindung, zum Beispiel Triethylphosphit, hergestellt.

Dabei sind folgende Kombinationen möglich:
1. Si-O-B-Verbindung (z. B. Tris(trimethylsilyl)borat) + elementorganische Phosphorverbindung (z. B. Trimethylphosphit)
2. Si-O-P-Verbindung (z. B. Tris(trimethylsilyl)phosphat) + elementorganische Borverbindung (z. B. Trimethylborat)
3. Si-O-P-Verbindung (z. B. Tris(trimethylsilyl)phosphat) + Si-O-B-Verbindung (z. B. Tris(trimethylsilyl)borat)

Die Aufbringung der Borphosphorsilikatglasschicht in einem konventionellen LPCVD-Heißwandreaktor (siehe FIG 1) erfolgt im Temperaturbereich von 300 bis 450° C bei einem Prozeßdruck von 50 bis 100 Pa. Die elementorganische Si-O-B-Verbindung und die elementorganische Phosphorverbindung werden dabei am Rohreingang des Reaktors eingelassen. Die Höhe der Bordotierung der abgeschiedenen Borphosphorsilikatglasschicht kann dabei durch geeignete Wahl der Si-O-B-Verbindung vorbestimmt werden, die Höhe der Phosphordotierung durch die Verdampfertemperatur der elementorganischen Phosphorverbindung, durch die Menge des durch die Phosphorverbindung hindurchperlenden Trägergases (Stickstoff oder Sauerstoff) oder durch geeignete Massendurchflußmesser. Typische Verdampfertemperaturen betragen für die Si-O-B-Verbindung und für die Phosphorverbindung 25 bis 90° C.

Die Aufbringung der Borphosphorsilikatglasschicht in einem konventionellen PECVD-Reaktor erfolgt im Temperaturbereich von 350 - 450° C bei einem Prozeßdruck von 0,8 - 1,3 kPa. Die Höhe der Bor- und der Phosphordotierung der abgeschiedenen Borphosphorsilikatglasschicht kann dabei sowohl durch geeignete Wahl der Si-O-B-Verbindung und/oder Si-O-P-Verbindung, dem Substituenten R am Silizium oder durch Variation der Prozeßparameter wie Verdampfertemperatur, Trägergasmenge (100 - 400 sccm He), O₂-Menge (10 -300 sccm), RF-Leistung (400 - 700 W), Elektrodenabstand (0,3 -0,6 cm), Prozeßdruck (0,8 - 1,3 kPa) oder Abscheidetemperatur (350 -450° C) vorbestimmt werden. Typische Verdampfertemperaturen betragen für die Si-O-B-Verbindung 25 bis 35° C und für die Si-O-P-Verbindung 25 bis 45° C.

Nach Abscheidung der Borphosphorsilikatglasschichten mit Dicken typischerweise zwischen 400 und 1500 nm werden die Schichten in einem anschließenden Prozeßschritt z. B. durch ROA (10 bis 140 sec, 900 bis 1150° C) verflossen und z. B. durch Abschleifen vollständig planarisiert.

4. Ausführungsbeispiel: Herstellung von Borarsensilikatglasschichten.

Bei der erfindungsgemäßen Durchführung des im folgenden dargestellten Verfahrens ist es möglich, Schichten zur Arsenausdiffusion in Silizium-Halbleitersubstrate herzustellen, die einen geringen Boranteil zur Stabilisierung des Glases enthalten, um Schädigungen des Substrates durch Ausbildung von Kristalliten bei der Arsenausdiffusion zur Erzeugung definierter Arsenprofile zu unterdrücken. Anstelle der Abscheidung einer reinen Arsensilikatglasschicht als Arsendiffusionsquelle werden nach der anisotropen Ätzung, zum Beispiel der Trenchzellen, diese mit einer Arsensilikatglasschicht ausgekleidet, die einen geringen Boranteil enthält, im folgenden Borarsensilikatglas genannt. Die Schichtaufbringung erfolgt im Bereich von 600 bis 800°C unter Verwendung einer Si-O-B-Verbindung mit einem hohen Verhältnis von Silizium zu Bor, zum Beispiel Tris(Triethylsilyl)borat, und einer elementorganischen Arsenverbindung, zum Beispiel Orthoarsensäuretriethylester, bei einem Prozeßdruck von 50 bis 100 Pa in einem konventionellen LPCVD-Heißwandreaktor. Die elementorganischen Dämpfe, sowohl der Si-O-B-Verbindung als auch der Arsenverbindung, werden dabei am Rohreingang des Reaktors eingelassen. Der Borgehalt der Borarsensilikatglasschicht ist typischerweise im Bereich von 0,5 bis 1 Gewichtsprozent, der Arsengehalt im Bereich von 5 bis 10 Gewichtsprozent. Typische Verdampfertemperaturen liegen bei 25 bis 90°C für die Si-O-B-Verbindung und 25 bis 40°C für die Arsenverbindung. Die weitere Bearbeitung der Borarsensilikatglasschicht zum Erzielen einer definierten Arsendotierung im Siliziumhalbleitersubstrat folgt im wesentlichen dem in der europäischen Patentanmeldung Nr. 87118186.3 vorgeschlagenen Verfahren.

5. Ausführungsbeispiel: Herstellung von Borarsensilikatglasschichten als Simultandiffusionsquellen für Bor und Arsen (Borarsensilikatglas-Abscheidung zum Erzielen einer definierten Bor- und Arsendotierung durch Simultandiffusion von Bor und Arsen im Silizium-Halbleitersubstrat).

Bei der erfindungsgemäßen Durchführung des im folgenden dargestellten Verfahrens ist es möglich, eine Borarsensilikatglasschicht abzuscheiden, die als Simultandiffusionquelle für Bor und Arsen verwendet werden kann. Dabei ist es möglich, in einem der Borarsensilikatglas-Abscheidung nachfolgenden Hochtemperaturschritt die Bor- und Arsenzielprofile unabhängig von den geometrischen Abmessungen der zu dotierenden Bereiche einzustellen.
a) Im Bereich des Kondensatorkomplexes bei höchstintegrierten Bauelementen, wie dem 4M-DRAM oder dem 16M-DRAM, kann simultan eine selbstjustierende Bordotierung (p-Wanne) und eine Arsendotierung (n⁺-Elektrode) erzeugt werden. Dabei werden anstelle des Wannenimplantationskomplexes und der anschließenden n⁺-Dotierung durch Ausdiffusion von Arsen aus einem Arsensilikatglas die Trenchzellen nach ihrer anisotropen Ätzung mit einer Borarsensilikatglasschicht als Simultandiffusionsquelle für Bor und Arsen ausgekleidet.
b) Bei der Formation der Transistoren wird anstelle des Implantationskomplexes zum Erzeugen von Basis, Gate, Emitter und Kollektor eine Borarsensilikatglasschicht als Simultandiffusionsquelle für Bor und Arsen abgeschieden.

Da es für eine gleichmäßige Dotierung des Silizium-Halbleitersubstrates wichtig ist, daß das Borarsensilikatglas eine gleichmäßige Dicke aufweist, zum Beispiel entlang der Trenchzellenwände, wird das Borarsensilikatglas durch pyrolytische Zersetzung einer Si-O-B-Verbindung, zum Beispiel Tris(triethylsilyl) borat, zusammen mit einer elementorganischen Arsenverbindung, zum Beispiel Orthoarsensäuretriethylester, hergestellt. Die Schichtherstellung erfolgt im 600 bis 850°C-Bereich bei Prozeßdrücken von 50 bis 100 Pa unter Beimischung von Sauerstoff in einem konventionellen LPCVD-Heißwandreaktor (siehe FIG 1). Die Dämpfe der Si-O-B-Verbindung und der Arsenverbindung werden dabei am Rohreingang des Reaktors eingelassen. Die Höhe der Bordotierung kann dabei durch geeignete Wahl der Si-O-B-Verbindung bzw. durch Modifikation des Siliziumsubstituenten R vorbestimmt werden, die Höhe der Arsendotierung durch die Verdampfertemperatur, die Menge der durch die Flüssigkeiten hindurchperlenden Trägergasmengen (Stickstoff oder Sauerstoff) und durch Variation der Abscheidebedingungen (Prozeßdruck, Abscheidetemperatur, Sauerstoff-Zumischung) eingestellt werden. Typische Verdampfertemperaturen betragen ca. 25 bis 90°C für die Si-O-B-Verbindung und 25 bis 40°C für die Arsenverbindung.

Nach Abscheidung der Borarsensilikatglasschichten mit Dicken von typischerweise 200 bis 400 nm wird in einem nachfolgenden Hochtemperaturschritt im Bereich von 850 bis 1050°C das Bor zusammen mit dem Arsen aus der Borarsensilikatglasschicht in das Siliziumhalbleitersubstrat eingetrieben. Dabei wird hauptsächlich die Tatsache ausgenützt, daß Bor und Arsen sehr unterschiedliche Diffusionsgeschwindigkeiten sowohl in der SiO₂-Matrix als auch im Siliziumeinkristall haben. Die Bor- und Arsenzielkonzentration im Substrat läßt sich dabei steuern über:
a) Bor- und Arsengehalt im Borarsensilikatglas (bzw. Verhältnis von Bor zu Arsen),
b) Temperatur des Diffusionsschrittes,
c) Dauer des Diffusionsschrittes,
d) Ambient des Diffusionsschrittes.

Typische Borgehalte sind 1 bis 5 Gewichtsprozent und Arsengehalte von 4 bis 8 Gewichtsprozent. Typische Temperbedingungen sind Temperaturen von 850 bis 1050°C bei Temperzeiten von 20 Minuten bis 2 Stunden in Stickstoff, Sauerstoff, Mischungen aus Stickstoff und Sauerstoff, Argon oder Wasserdampf. Im Anschluß an die Simultandiffusion von Bor und Arsen wird das Borarsensilikatglas zum Beispiel durch eine Naßätzung entfernt, die eine hohe Selektivität zum Silizium aufweist wie zum Beispiel gepufferte Flußsäure.

## Patentansprüche

1. Verfahren zum Herstellen borhaltiger und/oder phosphorhaltiger SiO₂-Schichten, nämlich Borsilikatglasschichten, Phosporsilikatglasschichten, Borphosphorsilikatglasschichten oder Borarsensilikatglasschichten, wie sie als Isolationsschichten zwischen Leitbahnebenen und/oder als Passivierungsschichten und/oder als Diffusionsquellen zur Erzeugung von dotierten Bereichen in Siliziumsubstraten bei der Herstellung höchstintegrierter Halbleiterschaltungen verwendet werden, durch Abscheidung der Schicht nach erfolgter Zersetzung von elementorganischen, die Elemente enthaltenden Verbindungen aus der Gasphase,
**dadurch gekennzeichnet**, daß für die Zersetzung solche elementorganische Verbindungen verwendet werden, welche die Boratome und/oder Phosphoratome, die Siliziumatome und die Sauerstoffatome bereits im vorgegebenen Verhältnis enthalten und daß die Zersetzung thermisch oder durch Anregung der Verbindungen in einem elektromagnetischen Wechselfeld durchgeführt wird.

2. Verfahren nach Anspruch 1,
**dadurch gekennzeichnet**, daß zum Herstellen einer borhaltigen SiO₂-Schicht eine Silizium-Bor-SauerstoffVerbindung verwendet wird mit der Konstitution (R₃SiO)₃B mit den Substituenten R = Wasserstoff, Alkyl, Cycloalkyl oder Aryl.

3. Verfahren nach Anspruch 1 oder 2,
**dadurch gekennzeichnet**, daß zum Herstellen einer borhaltigen SiO₂-Schicht Tristrimethylsilylborat (B(OSi(CH₃)₃)₃) verwendet wird.

4. Verfahren nach Anspruch 1,
**dadurch gekennzeichnet**, daß zum Herstellen einer borhaltigen SiO₂-Schicht eine Bor-Silizium-SauerstoffVerbindung verwendet wird mit der Konstitution (OBOSiR₃)₃ mit R = Wasserstoff, Alkyl, Cycloalkyl oder Aryl.

5. Verfahren nach Anspruch 4,
**dadurch gekennzeichnet**, daß folgende Verbindung verwendet wird

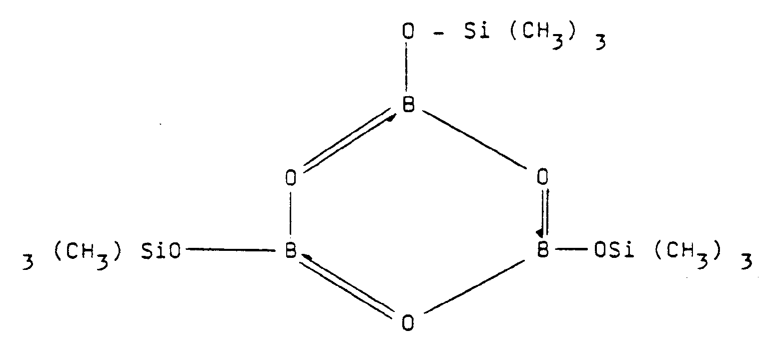

6. Verfahren nach Anspruch 1,
**dadurch gekennzeichnet**, daß zum Herstellen einer borhaltigen SiO₂-Schicht eine Bor-Silizium-SauerstoffVerbindung verwendet wird mit der Konstitution (R₃SiO)₂B-O-Si(R₂)-O-B(OSiR₃)₂ mit R = Wasserstoff, Alkyl, Cycloalkyl oder Aryl.

7. Verfahren nach Anspruch 6,
**dadurch gekennzeichnet**, daß folgende Verbindung verwendet wird

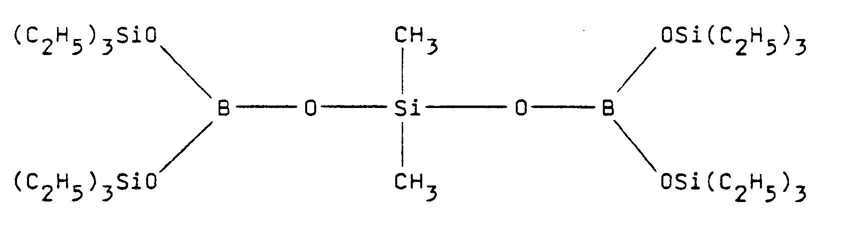

8. Verfahren nach Anspruch 1,
**dadurch gekennzeichnet**, daß zum Herstellen einer borhaltigen SiO₂-Schicht eine Bor-Silizium-Sauerstoff-Verbindung verwendet wird mit der Konstitution (R₃SiO)₂B-O-B(OSiR₃)₂ mit R = Wasserstoff, Alkyl, Cycloalkyl oder Aryl.

9. Verfahren nach Anspruch 8,
**dadurch gekennzeichnet**, daß folgende Verbindung verwendet wird

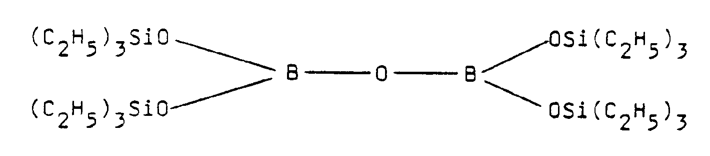

10. Verfahren nach Anspruch 1,
**dadurch gekennzeichnet,** daß zum Herstellen einer phosphorhaltigen SiO₂-Schicht eine Phosphor-Verbindung verwendet wird mit der Konstitution (RS5iO) (R′O)₂PO mit R und R′ = Wasserstoff, Alkyl, Cycloalkyl oder Aryl.

11. Verfahren nach Anspruch 1,
**dadurch gekennzeichnet**, daß zum Herstellen einer phosphorhaltigen SiO₂-Schicht eine Phosphor-Verbindung verwendet wird mit der Konstitution (R₃SiO)₂(R′O)PO mit R und R′ = Wasserstoff, Alkyl, Cycloakyl oder Aryl.

12. Verfahren nach Anspruch 1,
**dadurch gekennzeichnet**, daß zum Herstellen einer phosphorhaltigen SiO₂-Schicht eine Phosphor-Verbindung verwendet wird mit der Konstitution (R₃SiO)₃PO mit R = Wasserstoff, Alkyl, Cycloalkyl oder Aryl.

13. Verfahren nach Anspruch 1,
**dadurch gekennzeichnet**, daß zum Herstellen einer phosphorhaltigen SiO₂-Schicht eine Phosphor-Verbindung verwendet wird mit der Konstitution (RO)₂PO(OSi(OR′)₃) mit R und R′= Wassertoff, Alkyl, Cycloalkyl oder Aryl.

14. Verfahren nach Anspruch 1,
**dadurch gekennzeichnet,** daß zum Herstellen einer phosphorhaltigen SiO₂-Schicht eine Phosphor-Verbindung verwendet wird mit der Konstitution ((R′₃SiO)₃SiO)PO(OR)₂ mit R und R′ = Wassertoff, Alkyl, Cycloalkyl oder Aryl.

15. Verfahren nach Anspruch 1,
**dadurch gekennzeichnet**, daß zum Herstellen einer phosphorhaltigen SiO₂-Schicht eine Phosphor-Verbindung verwendet wird mit der Konstitution (R₃SiO) (R′O)₂P mit R und R′ = Wasserstoff, Alkyl, Cycloalkyl oder Aryl.

16. Verfahren nach Anspruch 1,
**dadurch gekennzeichnet**, daß zum Herstellen einer phosphorhaltigen SiO₂-Schicht eine Phosphor-Verbindung verwendet wird mit der Konstitution (R₃SiO)₂(R′O)₂P mit R und R′ = Wasserstoff, Alkyl, Cycloalkyl oder Aryl.

17. Verfahren nach Anspruch 1,
**dadurch gekennzeichnet**, daß zum Herstellen einer phosphorhaltigen SiO₂-Schicht eine Phosphor-Verbindung verwendet wird mit der Konstitution (R₃SiO)₃P mit R und R′ = Wasserstoff, Alkyl, Cycloalkyl oder Aryl.

18. Verfahren nach Anspruch 1,
**dadurch gekennzeichnet**, daß zum Herstellen einer phosphorhaltigen SiO₂-Schicht eine Phosphor-Verbindung verwendet wird mit der Konstitution (RO)₂P(OSi(OR′)₃) mit R und R′ = Wasserstoff, Alkyl, Cycloalkyl oder Aryl.

19. Verfahren nach Anspruch 1,
**dadurch gekennzeichnet,** daß zum Herstellen einer phosphorhaltigen SiO₂-Schicht eine Phosphor-Verbindung verwendet wird mit der Konstitution ((RO)₂PO)₃SiR′ mit R und R′= Wasserstoff, Alkyl, Cycloalkyl oder Aryl.

20. Verfahren nach einem der Ansprüche 1 bis 19,
**dadurch gekennzeichnet**, daß die Herstellung einer bor- und/oder phosphorhaltigen Silikatglasschicht in einer PECVD-Anlage durchgeführt wird, wobei die Verbindungen bei einer Temperatur von 25 bis 45° C verdampft und mittels eines Trägergases in den PECVD-Reaktor eingebracht werden und die Abscheidung der Silikatglasschicht bei einem Prozeßdruck von 0,8 bis 1,3 kPa, bei einer RF-Leistung von 300 bis 700 W, einem Elektrodenabstand von 0,3 bis 0,6 cm und einer Abscheidetemperatur von 350 bis 450°C durchgeführt wird.

21. Verfahren nach einem der Ansprüche 1 bis 9 und 20,
**dadurch gekennzeichnet,** daß zur Herstellung einer Borphosphorsilikatglasschicht eine Silizium-SauerstoffBor-Verbindung und eine Phosphor enthaltende Verbindung verwendet wird.

22. Verfahren nach einem der Ansprüche 1 und 10 bis 20,
**dadurch gekennzeichnet**, daß zur Herstellung einer Borphosphorsilikatglasschicht eine Silizium-Sauerstoff-Phosphorverbindung und eine Borverbindung verwendet wird.

23. Verfahren nach einem der Ansprüche 1 bis 20,
**dadurch gekennzeichnet**, daß zur Herstellung einer Borphosphorsilikatglasschicht eine Silizium-Sauerstoff-Bor-Verbindung und eine Silizium-Sauerstoff-Phosphor-Verbindung verwendet wird.

24. Verfahren nach einem der Ansprüche 10 bis 19,
**dadurch gekennzeichnet**, daß zur Herstellung einer Phosphorsilikatglasschicht als Passivierungsschicht für integrierte Schaltungen eine Silzium-Sauerstoff-Phosphor-Verbindung mit einem Phosphorgehalt von 5 bis 10 Gewichtsprozent und einem hohen Verhältnis von Phosphor- zu Sauerstoffatomen verwendet wird und die Phosphorsilikatglasschicht in einem PECVD-Reaktor abgeschieden wird.

25. Verfahren nach einem der Ansprüche 1 bis 9,
**dadurch gekennzeichnet**, daß zur Herstellung einer als Diffusionsquelle dienenden Bor und Phosphor bzw. Arsen enthaltenden Silikatglasschicht zusätzlich zu der Boratome, Siliziumatome und Sauerstoffatome in einem Molekül enthaltenden Verbindung eine organische Arsen- bzw. Phosphorverbindung zersetzt wird.

26. Verfahren nach Anspruch 25,
**dadurch gekennzeichnet**, daß Orthoarsensäuretriethylester verwendet wird.

27. Verfahren nach einem der Ansprüche 25 oder 26,
**dadurch gekennzeichnet**, daß zur Herstellung von grabenförmigen Kondensatorspeicherzellen (Trenchzellen) mit definierter p-Dotierung in Seitenwänden und Böden der Gräben Tristrimethylsilylborat in einem Temperaturbereich von 25 bis 90°C verdampft wird, bei 50 bis 400 Pa in einen Temperaturbereich von 200 bis 800°C thermisch zersetzt wird und die Borsilikatglasschicht abgeschieden wird, das Bor bei 850°C bis 1050°C in das Substrat eindiffundiert wird und die Borglasschicht anschließend entfernt wird.

28. Verfahren nach einem der Ansprüche 25 bis 27,
**dadurch gekennzeichnet**, daß zur Herstellung von grabenförmigen Kondensatorspeicherzellen (Trenchzellen) mit definierter p-Dotierung in Seitenwänden und Böden der Gräben sowie geringe Eindringtiefe der n⁺-Dotierung mit hoher Oberflächenkonzentration der Kondensatorelektrode gleichzeitig Tristriethylsilylborat mit Orthoarsensäuretriethylester bei 50 bis 100 Pa und 600 bis 850°C in Gegenwart von Sauerstoff thermisch zersetzt und als Simultandiffusionsquellenschicht im Substratgrabenbereich niedergeschlagen wird und Bor und Arsen gleichzeitig bei 850 bis 1050°C ausdiffundiert werden.

## Claims

1. Method for the manufacture of boron-containing and/or phosphorus-containing SiO₂ layers, specifically borosilicate glass layers, phosphosilicate glass layers, borophosphosilicate glass layers or boroarsenosilicate glass layers as used as insulating layers between interconnect levels, and/or as passivation layers and/or as diffusion sources for generating doped regions in silicon substrates in the manufacture of VLSI semiconductor circuits, by deposition of the layer after decomposition has taken place from the gas phase of organoelement compounds containing the elements, characterized in that the organoelement compounds used for the decomposition already contain the boron atoms and/or phosphorus atoms, the silicon atoms and the oxygen atoms in the prescribed ratio, and in that the decomposition is carried out thermally or by excitation of the compounds in an electromagnetic alternating field.

2. Method according to Claim 1,
characterized in that the manufacture of a boron-containing SiO₂ layer is effected using a silicon-boron-oxygen compound having the constitution (R₃SiO)₃B with the substituents R = hydrogen, alkyl, cycloalkyl or aryl.

3. Method according to Claim 1 or 2,
characterized in that the manufacture of a boron-containing SiO₂ layer is effected using tristrimethylsilyl borate (B(OSi(CH₃)₃)₃).

4. Method according to Claim 1,
characterized in that the manufacture of a boron-containing SiO₂ layer is effected using a boron-silicon-oxygen compound having the constitution (OBOSiR₃)₃ with R = hydrogen, alkyl, cycloalkyl or aryl.

5. Method according to Claim 4,
characterized in that the following compound is used

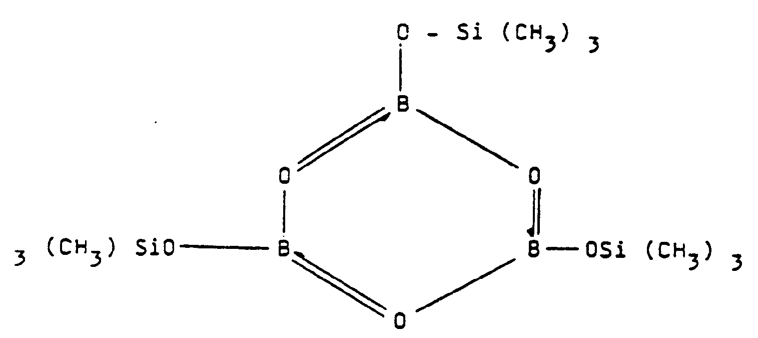

6. Method according to Claim 1,
characterized in that the manufacture of a boron-containing SiO₂ layer is effected using a boron-silicon-oxygen compound having the constitution (R₃SiO)₂B-O-Si(R₂)-O-B(OSiR₃)₂ with R = hydrogen, alkyl, cycloalkyl or aryl.

7. Method according to Claim 6,
characterized in that the following compound is used:

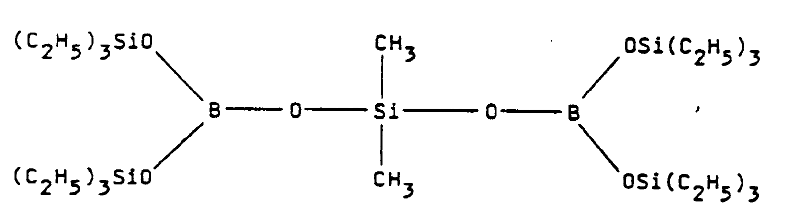

8. Method according to Claim 1,
characterized in that the manufacture of a boron-containing SiO₂ layer is effected using a boron-silicon-oxygen compound having the constitution (R₃SiO)₂B-O-B(OSiR₃)₂ with R = hydrogen, alkyl, cycloalkyl or aryl.

9. Method according to Claim 8,
characterized in that the following compound is used:

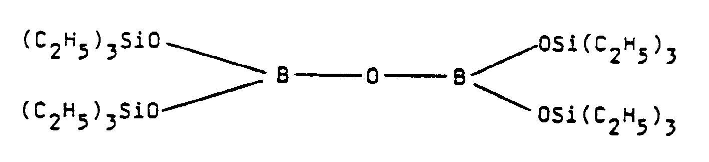

10. Method according to Claim 1,
characterized in that the manufacture of a phosphorus-containing SiO₂ layer is effected using a phosphorus compound having the constitution (R₃SiO)(R′O)₂PO with R and R′ = hydrogen, alkyl, cycloalkyl or aryl.

11. Method according to Claim 1,
characterized in that the manufacture of a phosphorus-containing SiO₂ layer is effected using a phosphorus compound having the constitution (R₃SiO)₂(R′O)PO with R and R′ = hydrogen, alkyl, cycloalkyl or aryl.

12. Method according to Claim 1,
characterized in that the manufacture of a phosphorus-containing SiO₂ layer is effected using a phosphorus compound having the constitution (R₃SiO)₃PO with R = hydrogen, alkyl, cycloalkyl or aryl.

13. Method according to Claim 1,
characterized in that the manufacture of a phosphorus-containing SiO₂ layer is effected using a phosphorus compound having the constitution (RO)₂PO(OSi(OR′)₃) with R and R′ = hydrogen, alkyl, cycloalkyl or aryl.

14. Method according to Claim 1,
characterized in that the manufacture of a phosphorus-containing SiO₂ layer is effected using a phosphorus compound having the constitution ((R′₃SiO)₃SiO)PO(OR)₂ with R and R′ = hydrogen, alkyl, cycloalkyl or aryl.

15. Method according to Claim 1,
characterized in that the manufacture of a phosphorus-containing SiO₂ layer is effected using a phosphorus compound having the constitution (R₃SiO) (R′O)₂P with R and R′ = hydrogen, alkyl, cycloalkyl or aryl.

16. Method according to Claim 1,
characterized in that the manufacture of a phosphorus-containing SiO₂ layer is effected using a phosphorus compound having the constitution (R₃SiO)₂(R′O)₂P with R and R′ = hydrogen, alkyl, cycloalkyl or aryl.

17. Method according to Claim 1,
characterized in that the manufacture of a phosphorus-containing SiO₂ layer is effected using a phosphorus compound having the constitution (R₃SiO)₃P with R and R′ = hydrogen, alkyl, cycloalkyl or aryl.

18. Method according to Claim 1,
characterized in that the manufacture of a phosphorus-containing SiO₂ layer is effected using a phosphorus compound having the constitution (RO)₂P(OSi(OR′)₃) with R and R′ = hydrogen, alkyl, cycloalkyl or aryl.

19. Method according to Claim 1,
characterized in that the manufacture of a phosphorus-containing SiO₂ layer is effected using a phosphorus compound having the constitution ((RO)₂PO)₃SiR′ with R and R′ = hydrogen, alkyl, cycloalkyl or aryl.

20. Method according to any one of Claims 1 to 19,
characterized in that the manufacture of a boron- and/or phosphorus-containing silicate glass layer is carried out in a PECVD installation, the compounds being evaporated at a temperature of from 25 to 45°C and being introduced into the PECVD reactor by means of a carrier gas, and the deposition of the silicate glass layer being performed at a process pressure of from 0.8 to 1.3 kPa, an RF power of from 300 to 700 W, an electrode spacing of from 0.3 to 0.6 cm and a deposition temperature of from 350 to 450°C.

21. Method according to any one of Claims 1 to 9 and 20,
characterized in that the manufacture of a borophosphosilicate glass layer is effected using a silicon-oxygen-boron compound and a phosphorus-containing compound.

22. Method according to any one of Claims 1 and 10 to 20,
characterized in that the manufacture of a borophospho-silicate glass layer is effected using a silicon-oxygen-phosphorus compound and a boron compound.

23. Method according to any one of Claims 1 to 20,
characterized in that the manufacture of a borophosphosilicate glass layer is effected using a silicon-oxygen-boron compound and a silicon-oxygen-phosphorus compound.

24. Method according to any one of Claims 10 to 19,
characterized in that the manufacture of a phosphosilicate glass layer as a passivation layer for integrated circuits is effected using a silicon-oxygen-phosphorus compound with a phosphorus content of from 5 to 10 per cent by weight and a high ratio of phosphorus to oxygen atoms, and the phosphosilicate glass layer is deposited in a PECVD reactor.

25. Method according to any one of Claims 1 to 9,
characterized in that the manufacture of a silicate glass layer serving as a diffusion source and containing boron and phosphorus or arsenic is effected by decomposing, in addition to the compound containing boron atoms, silicon atoms and oxygen atoms in one molecule, an organic arsenic or phosphorus compound.

26. Method according to Claim 25,
characterized in that triethyl orthoarsenate is used.

27. Method according to Claim 25 or 26,
characterized in that, for the purpose of manufacturing trench-shaped capacitor storage cells (trench cells) having defined p-type doping in side walls and floors of the trenches, tristrimethylsilyl borate is evaporated in a temperature range of from 25 to 90°C and thermally decomposed at from 50 to 400 Pa in a temperature range of from 200 to 800°C, the borosilicate glass layer is deposited, the boron is diffused into the substrate at from 850°C to 1050°C, and the borate glass layer is then removed.

28. Method according to any one of Claims 25 to 27,
characterized in that, for the purpose of manufacturing trench-shaped capacitor storage cells (trench cells) having defined p-type doping in side walls and floors of the trenches, and low penetration depth of the n⁺-type doping with high surface concentration of the capacitor electrode, tristriethylsilyl borate and triethyl orthoarsenate are simultaneously thermally decomposed at from 50 to 100 Pa and from 600 to 850°C in the presence of oxygen and deposited as a simultaneous diffusion source layer in the substrate trench zone, and boron and arsenic are simultaneously diffused out at from 850 to 1050°C.

## Revendications

1. Procédé de fabrication de couches en SiO₂ borées et/ou phosphorées, à savoir de couches en verre au borosilicate, de couches en verre au phosphosilicate, de couches en verre au borophosphosilicate ou de couches en verre au boroarsénosilicate, telles qu'on les utilise comme couches isolantes entre des plans de voies conductrices et/ou comme couches de passivation et/ou comme sources de diffusion pour produire des domaines dopés dans des substrats en silicium lors de la fabrication de circuits à semiconducteurs à très haute intégration, par dépôt en phase gazeuse de la couche après avoir effectué la décomposition de composés organo-élémentaires qui renferment les éléments caractérisé en ce qu'il consiste à utiliser pour la décomposition des composés organo-élémentaires qui renferment déjà en le rapport prescrit les atomes de bore et/ou les atomes de phosphore, les atomes de silicium et les atomes d'oxygène, et à effectuer la décomposition thermiquement ou par excitation du composé dans un champ alternatif électromagnétique.

2. Procédé suivant la revendication 1, caractérisé en ce qu'il consiste à utiliser, pour la fabrication d'une couche en SiO₂ borée, un composé silicium-bore-oxygène de constitution (R₃SiO)₃B avec les substituants R = hydrogène, alcoyle, cycloalcoyle ou aryle.

3. Procédé suivant la revendication 1 ou 2, caractérisé en ce qu'il consiste à utiliser pour la fabrication d'une couche en SiO₂ borée, du borate de tristriméthylsilyle (B(OSi(CH₃)₃)₃).

4. Procédé suivant la revendication 1, caractérisé en ce qu'il consiste à utiliser, pour la fabrication d'une couche en SiO₂ borée, un composé de bore-silicium-oxygène de constitution (OBOSiR₃)₃ avec R = hydrogène, alcoyle, cycloalcoyle ou aryle.

5. Procédé suivant la revendication 4, caractérisé en ce qu'il consiste à utiliser le composé suivant:

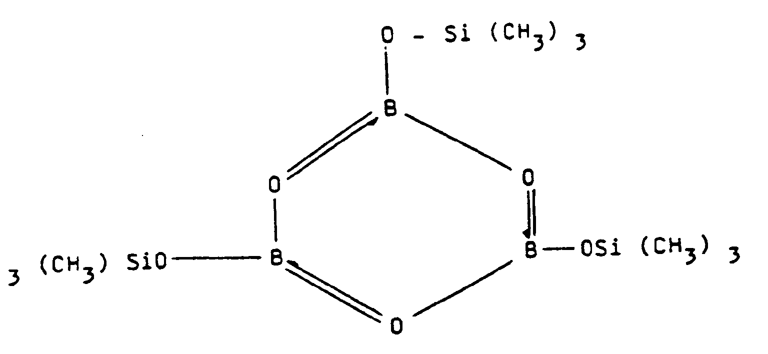

6. Procédé suivant la revendication 1, caractérisé en ce qu'il consiste, pour fabriquer une couche en SiO₂ borée, à utiliser un composé bore-silicium-oxygène de constitution (R₃SiO)₂B-O-Si(R₂)-O-B(OSiR₃)₂ avec R = hydrogène, alcoyle, cycloalcoyle ou aryle.

7. Procédé suivant la revendication 6, caractérisé en ce qu'il consiste à utiliser le composé suivant

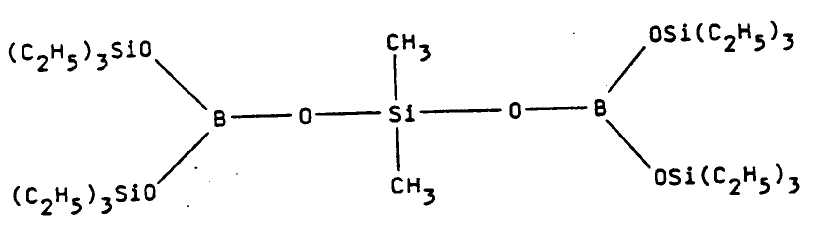

8. Procédé suivant la revendication 1, caractérisé en ce qu'il consiste, pour fabriquer une couche en SiO₂ borée, à utiliser un composé de bore-silicium-oxygène de constitution (R₃SiO)₂B-O-B(OSiR₃)₂ avec R = hydrogène, alcoyle, cycloalcoyle ou aryle.

9. Procédé suivant la revendication 8, caractérisé en ce qu'il consiste à utiliser le composé suivant

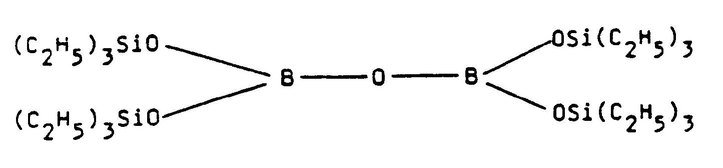

10. Procédé suivant la revendication 1, caractérisé en ce qu'il consiste, pour fabriquer une couche en SiO₂ phosphorée, à utiliser un composé phosphoré de constitution (R₃SiO) (R′O)₂PO avec R et R′ = hydrogène, alcoyle, cycloalcoyle ou aryle.

11. Procédé suivant la revendication 1, caractérisé en ce qu'il consiste, pour fabriquer une couche en SiO₂ phosphorée, à utiliser un composé phosphoré de constitution (R₃SiO)₂(R′O)PO avec R et R′ = hydrogène, alcoyle, cycloalcoyle ou aryle.

12. Procédé suivant la revendication 1, caractérisé en ce qu'il consiste, pour fabriquer une couche en SiO₂ phosphorée, à utiliser un composé phosphoré de constitution (R₃SiO)₃PO avec R = hydrogène, alcoyle, cycloalcoyle ou aryle.

13. Procédé suivant la revendication 1, caractérisé en ce qu'il consiste, pour fabriquer une couche en SiO₂ phosphorée, à utiliser un composé phosphoré de constitution (RO)₂PO(OSi(OR′)₃) avec R et R′ = hydrogène, alcoyle, cycloalcoyle ou aryle.

14. Procédé suivant la revendication 1, caractérisé en ce qu'il consiste, pour fabriquer une couche en SiO₂ phosphorée, à utiliser un composé phosphoré de constitution (R′₃SiO)₃SiO)PO(OR)₂ avec R et R′ = hydrogène, alcoyle, cycloalcoyle ou aryle.

15. Procédé suivant la revendication 1, caractérisé en ce qu'il consiste, pour fabriquer une couche en SiO₂ phosphorée, à utiliser un composé phosphoré de constitution (R₃SiO) (R′O)₂P avec R et R′ = hydrogène, alcoyle, cycloalcoyle ou aryle.

16. Procédé suivant la revendication 1, caractérisé en ce qu'il consiste, pour fabriquer une couche en SiO₂ phosphorée, à utiliser un composé phosphoré de constitution (R₃SiO)2(R′O)₂P avec R et R′ = hydrogène, alcoyle, cycloalcoyle ou aryle.

17. Procédé suivant la revendication 1, caractérisé en ce qu'il consiste, pour fabriquer une couche en SiO₂ phosphorée, à utiliser un composé phosphoré de constitution (R₃SiO)₃P avec R et R′ = hydrogène, alcoyle, cycloalcoyle ou aryle.

18. Procédé suivant la revendication 1, caractérisé en ce qu'il consiste, pour fabriquer une couche en SiO₂ phosphorée, à utiliser un composé phosphoré de constitution (RO)₂P(OSi(OR′)₃) avec R et R′ = hydrogène, alcoyle, cycloalcoyle ou aryle.

19. Procédé suivant la revendication 1, caractérisé en ce qu'il consiste, pour fabriquer une couche en SiO₂ phosphorée, à utiliser un composé phosphoré de constitution ((RO)₂PO)₃SiR′ avec R et R′ = hydrogène, alcoyle, cycloalcoyle ou aryle.

20. Procédé suivant l'une des revendications 1 à 19,
caractérisé en ce qu'il consiste à effectuer la fabrication d'une couche de verre au borosilicate et/ou au phosphosilicate dans une installation PECVD, en volatilisant les composés à une température de 25 à 45°C et en les introduisant au moyen d'un gaz support dans un réacteur PECVD et en effectuant le dépôt de la couche de verre au silicate sous une pression du procédé de 0,8 à 1,3kPa, à une puissance haute fréquence de 300 à 700 W, avec un intervalle entre les électrodes de 0,3 à 0,6 cm et à une température de dépôt de 350 à 450°C.

21. Procédé suivant l'une des revendications 1 à 9 et 20,
caractérisé en ce qu'il consiste, pour la fabrication d'une couche en verre au borophosphosilicate, à utiliser un composé de silicium-oxygene-bore et un composé phosphoré.

22. Procédé suivant l'une des revendications 1 et 10 à 20,
caractérisé en ce qu'il consiste, pour fabriquer une couche en verre au borophosphosilicate, à utiliser un composé de silicium-oxygène-phosphore et un composé boré.

23. Procédé suivant l'une des revendications 1 à 20,
caractérisé en ce qu'il consiste, pour fabriquer une couche en verre au borophosphosilicate, à utiliser un composé de silicium-oxygène-bore et un composé de silicium-oxygène-phosphore.

24. Procédé suivant l'une des revendications 10 à 19,
caractérisé en ce qu'il consiste, pour fabriquer une couche en verre au phosphosilicate servant de couche de passivation pour des circuits intégrés, à utiliser un composé de silicium-oxygène-phosphore ayant une teneur en phosphore de 5 à 10 % en poids et un grand rapport des atomes de phosphore aux atomes d'oxygène et à effectuer le dépôt de la couche en verre au phosphosilicate dans un réacteur PECVD.

25. Procédé suivant l'une des revendications 1 à 9,
caractérisé en ce qu'il consiste, pour fabriquer une couche en verre au silicate renfermant du bore et du phosphore ou de l'arsenic et servant de source de diffusion, à décomposer, en plus du composé renfermant dans la molécule des atomes de bore, des atomes de silicium et des atomes d'oxygène, un composé organique de l'arsenic ou du phosphore.

26. Procédé suivant la revendication 25,
caractérisé en ce qu'il consiste à utiliser l'ester triéthylique de l'acide orthoarsénique.

27. Procédé suivant l'une des revendications 25 ou 26,
caractérisé en ce qu'il consiste, pour fabriquer des cellules de mémoire à condensateur en forme de sillons (cellules Trench) à dopage p défini dans les parois latérales et dans les fonds des sillons, à volatiliser du borate de tristiméthylsilyle dans un intervalle de température de 25 à 90°C, à le décomposer thermiquement entre 50 et 400 Pa dans un intervalle de température de 200 à 800°C et à déposer la couche en verre au borosilicate, à faire diffuser le bore entre 850°C et 1050°C dans le substrat et à enlever ensuite la couche de verre au bore.

28. Procédé suivant l'une des revendications 25 à 27,
caractérisé en ce qu'il consiste, pour fabriquer des cellules de mémoire à condensateurs en forme de sillons (cellules Trench) à dopage p défini dans les parois latérales et dans les fonds des sillons ainsi qu'à faible profondeur de pénétration du dopage n⁺, avec une grande concentration superficielle des électrodes formant condensateur, à décomposer en même temps du borate de tristriéthylsilyle et de l'ester éthylique de l'acide orthoarsénique entre 50 et 100 Pa et entre 600 et 850°C en présence d'oxygène et à les précipiter sous forme de couche de sources de diffusion simultanée dans la partie des sillons de substrat et à faire diffuser du bore et de l'arsenic en même temps entre 850 et 1050°C.
